# EUROPEAN PATENT SPECIFICATION

(11) **EP 3 340 223 B1**
(45) Date of publication and mention of the grant of the patent: **26.01.2022**
(21) Application number: 17204635.1
(22) Date of filing: 30.11.2017
(51) Int. Cl.: G09G 3/3233

(54) **ELECTROLUMINESCENT DISPLAY AND METHOD OF DRIVING THE SAME**
ELEKTROLUMINESZIERENDE ANZEIGE UND VERFAHREN ZU DEREN ANSTEUERUNG
AFFICHAGE ÉLECTROLUMINESCENT ET SON PROCÉDÉ DE COMMANDE

(30) Priority: 22.12.2016 KR 20160176663
(43) Date of publication of application: 27.06.2018
(73) Proprietor: LG Display Co., Ltd., Seoul, 07336 (KR)
(72) Inventor: PARK, Eunji, 10845 Paju-si, Gyeonggi-do (KR); KIM, Bumsik, 10845 Paju-si, Gyeonggi-do (KR); HAN, Sungman, 10845 Paju-si, Gyeonggi-do (KR); LEE, Kihyung, 10845 Paju-si, Gyeonggi-do (KR)
(74) Representative: Viering, Jentschura & Partner mbB Patent- und Rechtsanwälte

(56) References cited:
- EP-A2- 2 996 108
- US-A1- 2010 141 564
- US-A1- 2010 149 079

## Description

### BACKGROUND

### Field of Technology

The present disclosure relates to an electroluminescent display and a method of driving the same.

### Discussion of the Related Art

As information technology is developed, a market for a display device, which is a connection medium between a user and information, is increasing. Accordingly, use of display devices such as an electroluminescent display (ELD), a liquid crystal display (LCD), and a plasma display panel (PDP) is increasing.

The electroluminescent display of the display devices described above includes a display panel having a plurality of sub-pixels, and a driver configured to drive the display panel. The driver includes a scan driver configured to supply a scan signal (or a gate signal) to the display panel, and a data driver configured to supply a data signal to the display panel.

The electroluminescent display has a problem that electric characteristics (threshold voltage, electron mobility, etc.) of a driving transistor included in a sub-pixel change during long-time use. In order to compensate for this, conventionally, the electric characteristics of the driving transistor are compensated within the sub-pixel (internal compensation method) or externally compensated (external compensation method).

However, among the conventional compensation method, there is a problem that a block dim (a luminance variation that a luminance of a block shape becomes dark) occurs on the display panel due to a leakage current in the internal compensation, and improvement thereof is required.

EP 2 996 108 A2 (prior art document D1) is entitled *"Pixel circuit, display device, and method of driving pixel circuit"* and proposes pixel circuitry that achieves a constant flow of OLED current corresponding to an input voltage (Vin) even if the current/voltage (I-V) characteristic of the OLED (embodying an EL light emitting element) deteriorates over emission time (paragraphs 0113/0114, 0153, 0198, 0249, 0295, 0349). D1 also considers an *"off current"* flowing to the EL light emitting element during non-emitting periods (paragraphs 0185, 0232, 0276, 0331). According to Figures 31A...31E of D1, a switching transistor 313 is arranged between a driving transistor 311 and an anode of an EL light-emitting element 315 (e.g. an OLED):
- Figure 31A (or 31E) depicts an operating state of the pixel circuit in which two other switching transistors (312, 314) are turned off while the switching transistor 313 is turned on (paragraphs 0272, 0288).
- Figure 31B depicts an operating state of the pixel circuit in which the switching transistors 312, 314 are held in the off state and the switching TFT 313 is also turned off (paragraph 0275). In this manner, the pixel circuit can be operated without supplying current during the non-emitting period so as to reduce the power consumption of the panel (paragraph 0279). The switching transistor 314 is connected to a reference line (constant voltage source 307; paragraph 0282).
- Figure 31D depicts an operating state of the pixel circuit in which only one (312) of the other switching transistors is held in the off state and the switching TFT 313 is also turned off (paragraph 0285).

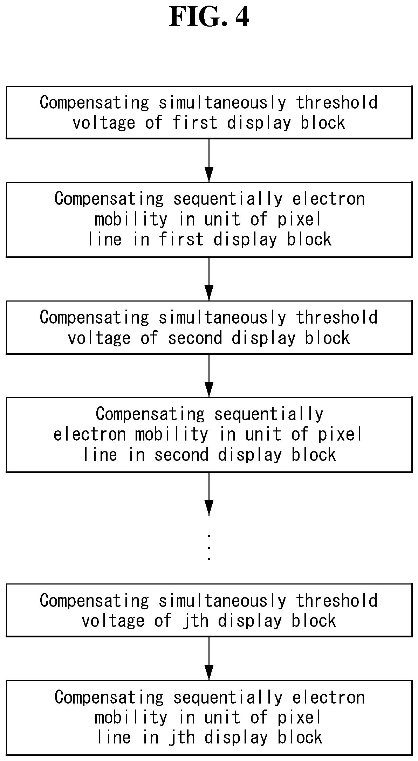

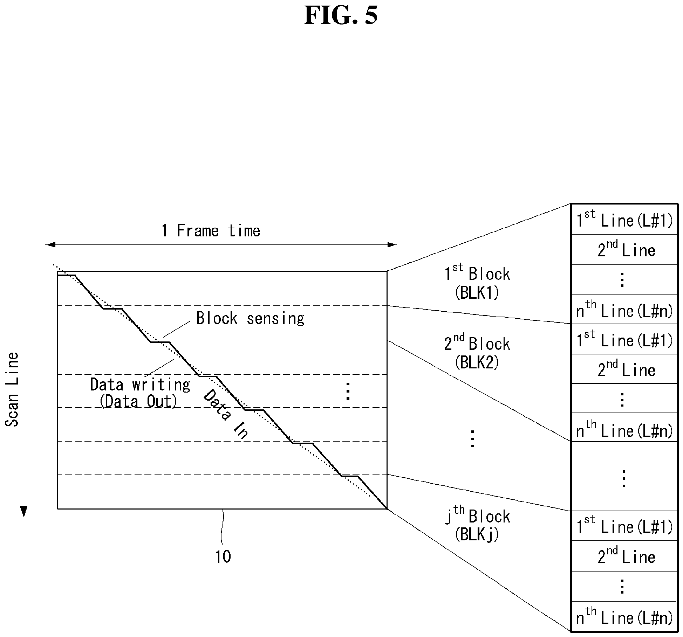

US 2010/0141564 A1 (prior art document D2) is entitled *"Pixel and organic light emitting display device using the same"* and seeks to provide a pixel which may compensate for the deterioration of an OLED over time (paragraphs 0006, 0008). Figure 5 shows a pixel (140') comprising a pixel circuit (142) which has a driving transistor (M2), a first switching transistor (M1), a second switching transistor (M4) and a third switching transistor (M3). The first and second switching transistors (M1, M4) are jointly controlled by a scan control signal (Sn), and the third switching transistor (M3) is controlled by an emission control signal (En) (see Figure 4 and paragraphs 0053...0058, 0064/0065). All those transistors have inverted gate functions, i.e. they are turned on by low gate voltage levels. Accordingly, the waveform diagram of Figure 4 implies that all the switching transistors (M1, M3, M4) are turned off during time periods T1 and T3. During an emission time period T4, the third switching transistor (M3) is turned on while the first and second switching transistors (M1, M4) are turned off. The supply voltage ELVDD in Figure 5 of D2 may be considered to represent a reference voltage.

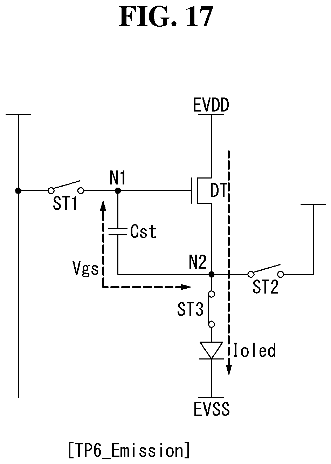

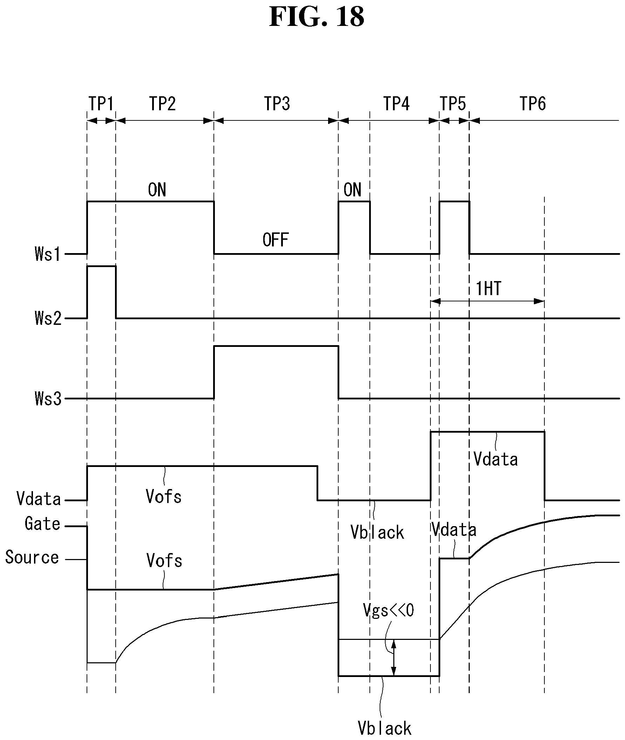

US 2010/0149079 A1 (prior art document D3) is entitled *"Display device, method of driving display device, and electronic apparatus"* and addresses the problem that the current/luminance characteristic of the light-emitting element tends deteriorate over time. D3 seeks to provide a display device which can compensate for the degradation in luminance of pixels (paragraphs 0007/0008). D3 proposes to use a light-receiving element (photo diode PD) and to correct the video signal in response to the luminance signal outputted from the light-receiving element of each pixel and to supply the corrected video signal to the drive section. Thus, the degradation in luminance of the pixels can be compensated (paragraph 0011). A pixel circuit shown in Figure 17 of D3 comprises a driving transistor (Trd), a first switching transistor (Tr1), a second switching transistor (Tr3), and a third switching transistor (Tr4). The second and third switching transistors (Tr3, Tr4) share a control signal (scanning line SS). The second switching transistor (Tr3) has a non-inverted gate function while the third switching transistor (Tr4) has an inverted gate function. Hence, as illustrated in Figure 18, when the third switching transistor Tr4 is off, the second switching transistor Tr3 is on, and *vice versa.* The first and third switching transistors (Tr1, Tr4) may be off at the same time.

### SUMMARY

In one aspect, there is provided an electroluminescent display according to claim 1.

In another aspect, there is provided a method of driving an electroluminescent display comprising the steps of claim 3.

Further preferred embodiments are set out in the dependent claims.

### BRIEF DESCRIPTION OF THE DRAWINGS

The accompanying drawings, which are included to provide a further understanding of the present disclosure and are incorporated in and constitute a part of this specification, illustrate examples falling outside the scope of the appended claims, as well as embodiments of the present disclosure and together with the description serve to explain the principles of the present disclosure. In the drawings:
FIG. 1 is a schematic block diagram of an organic electroluminescent display;
FIG. 2 is a diagram illustrating a pixel array formed on a display panel of FIG. 1;
FIG. 3 is a flowchart illustrating a method of driving for sufficiently securing a threshold voltage compensation period in compensating an electrical characteristic deviation of a driving transistor in compliance with a source-follower type internal compensation method;
FIGS. 4 to 6 are diagrams illustrating a method of driving in which a non-overlapping compensating operation is performed between neighboring display blocks while compensating an electric characteristic deviation of a driving transistor by a method of FIG. 3;
FIG. 7 is a diagram illustrating a method of driving in which an overlapping compensating operation is performed between neighboring display blocks while compensating an electric characteristic deviation of a driving transistor by a method of FIG. 3;
FIG. 8 is a circuit configuration diagram of a sub-pixel according to a comparative example;
FIG. 9 is a diagram illustrating driving waveforms of a sub-pixel shown in FIG. 8; FIG. 1 to FIG. 8 inclusive illustrating examples that fall outside the scope of the appended claims;
FIG. 10 is a circuit configuration diagram of a sub-pixel according to an embodiment of the present disclosure;
FIG. 11 is a diagram illustrating driving waveforms of a sub-pixel shown in FIG. 10 according to an embodiment;
FIGS. 12 to 17 are diagrams illustrating operation states by period of a sub-pixel according to an embodiment;
FIG. 18 is a first modification illustrating driving waveforms of a sub-pixel shown in FIG. 10 according to an embodiment;
FIG. 19 is a second modification illustrating driving waveforms of a sub-pixel shown in FIG. 10 according to an embodiment; and
FIG. 20 is a third modification illustrating driving waveforms of a sub-pixel shown in FIG. 10 according to an embodiment.

### DETAILED DESCRIPTION

Reference will first be made to comparative examples, rather than embodiments of the present disclosure, examples of which are illustrated in the accompanying drawings. Discussion of the claimed embodiments commences under the subheading "Embodiment" below.

A display device according to the present disclosure may be implemented by a television, a video player, a personal computer (PC), a home theater, a smart phone, and the like, but is not limited thereto. An electroluminescent display described below is an example of an organic electroluminescent display implemented based on an organic light emitting diode. However, the electroluminescent display described below may be implemented based on organic light emitting diodes or inorganic light emitting diodes. The present disclosure is not limited to the electroluminescent display but may be applied to a display device of a similar type. In the following description, a thin film transistor will be described as a transistor.

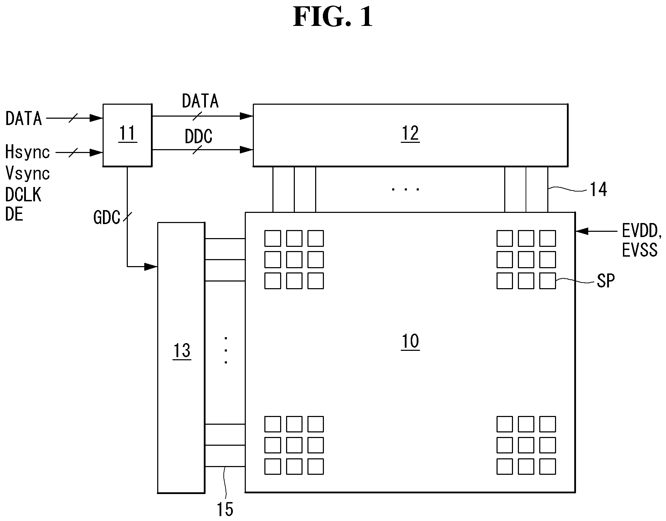

**FIG. 1** is a schematic block diagram of an organic electroluminescent display.

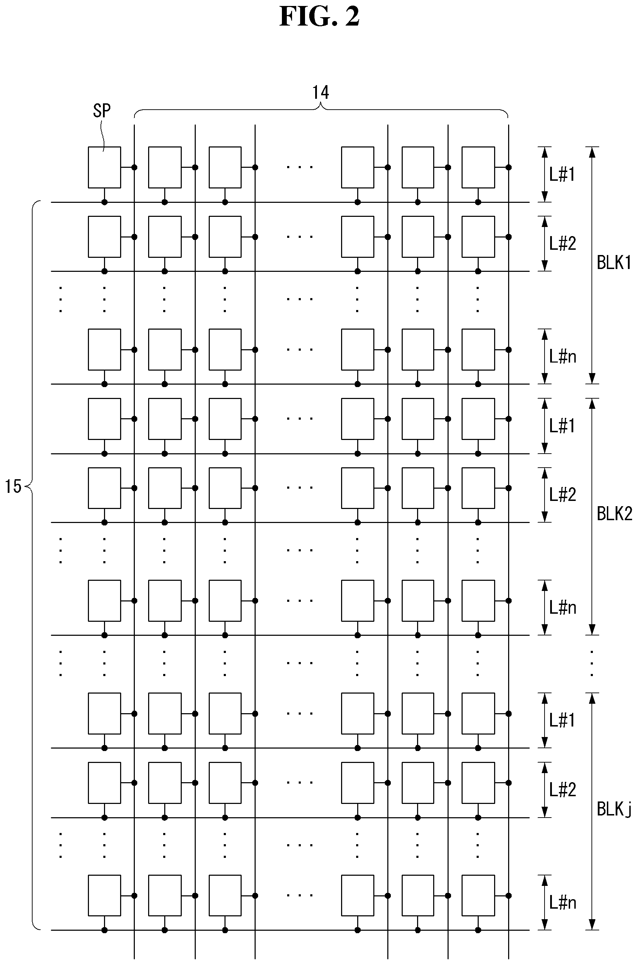

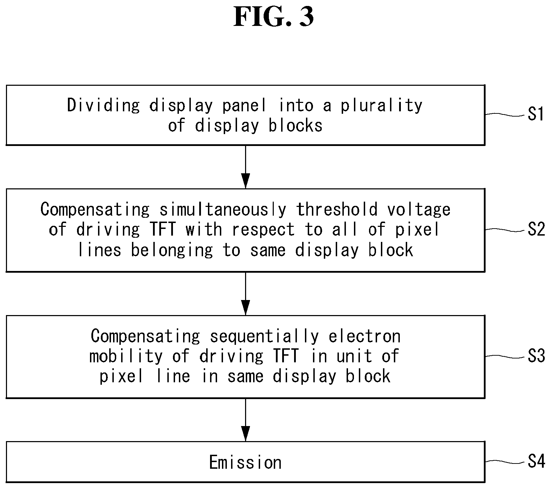

**FIG. 2** is a diagram illustrating a pixel array formed on a display panel of FIG. 1. **FIG. 3** is a flowchart illustrating a method of driving for sufficiently securing a threshold voltage compensation period in compensating an electrical characteristic deviation of a driving transistor in compliance with a source-follower type internal compensation method.

As shown in FIGS. 1 and 2, an organic electroluminescent display according to the present disclosure includes a display panel 10, a data driver 12, a gate driver 13, and a timing controller 11.

Data lines 14 and scan lines 15 are arranged in the display panel 10. Sub-pixels SP are arranged in each intersection of the data lines 14 and the scan lines 15. The sub-pixels SP are supplied with a high potential driving voltage EVDD and a low potential driving voltage EVSS from a power generating unit (not shown). The sub-pixels SP include an organic light emitting diode and a driving transistor, respectively. The sub-pixels SP compensate a threshold voltage and an electron mobility of the driving transistor in compliance with a source-follower type internal compensation method, and display a desired grayscale holding a gate-source voltage of the driving transistor set for about one frame period at the time of compensation.

The sub-pixels SP include at least one switching transistor that is switched to control a gate potential of the driving transistor. In the sub-pixels SP, a source potential of the driving transistor can be controlled through switching operation of a switching transistor, and in some instances, it can be controlled by swing of the high potential driving voltage.

At least one switching transistor of the sub-pixels SP is switched by a scan signal applied from the scan lines 15. The sub-pixels SP may have a different structure as long as the source-follower type internal compensation method can be applied.

A pixel array as shown in FIG. 2 is formed on the display panel 10 by the sub-pixels SP arranged in a matrix form. The pixel array may be divided into a plurality of display blocks BLK1 to BLKj along a supply direction (e.g., vertical direction) of a data signal, and each display block may include a plurality of pixel lines L#1 to L#n. One pixel line means a set of sub-pixels SP arranged in the same horizontal direction and simultaneously receiving a data voltage. The number of the pixel lines L#1 to L#n included in each display block can be set to an appropriate number so as to secure a sufficient threshold voltage compensation period.

The data driver 12 drives the data lines 14 under a control of the timing controller 11. The data driver 12 generates a data voltage corresponding to the data signal DATA in accordance with a data timing control signal DDC applied from the timing controller 11 and supplies the data voltage to the data lines 14. The data voltage means a grayscale voltage for image display. The data voltage may be applied in a multi-step form including an offset voltage and / or a pre-charge voltage together with the grayscale voltage for image display in some instances.

The gate driver 13 drives gate signal supply lines 15 under a control of the timing controller 11. The gate driver 13 generates a scan signal in accordance with a gate timing control signal GDC from the timing controller 11 and supplies the scan signal to the scan lines 15 assigned to respective pixel lines L#1 to L#n. The scan signal supplied to the scan lines 15 of one pixel line includes a gate potential control scan signal used for controlling the gate potential of the driving transistor and a source potential control scan signal used for controlling the source potential of the driving transistor. The gate driver 13 may be formed directly on the display panel 10 in a gate-driver in panel (GIP) manner.

The timing controller 11 generates the data timing control signal DDC for controlling operation timing of the data driver 12 and the gate timing control signal GDC for controlling operation timing of the gate driver 13 based on timing signals such as a vertical synchronization signal Vsync, a horizontal synchronization signal Hsync, a dot clock signal DCLK, and a data enable signal DE. The timing controller 11 processes the data signal DATA applied from an external video source (not shown) and supplies the processed data signal to the data driver 12.

The timing controller 11 controls operation of the data driver 12 and the gate driver 13. While the timing controller 11 sequentially compensates the threshold voltage and the electron mobility of the driving transistor in a unit of display block, the timing controller 11 simultaneously compensates the threshold voltage of the driving transistor with respect to all pixel lines L#1 to L#n belonging to the same display block. The timing controller 11 can sequentially compensate the electron mobility of the driving transistor in a unit of pixel line in the same display block in order to sufficiently secure the threshold voltage compensation period within one frame period to improve a compensation performance.

Unlike the related art, the present disclosure simultaneously allocates time required for threshold voltage compensation for each display block to simultaneously compensate the threshold voltage in one display block, and then compensates the electron mobility by writing a data voltage in a line sequential manner in the corresponding display block. The time (block compensation time) allocated to the threshold voltage compensation can be determined depending on the number of pixel lines belonging to one display block. The block compensation time can be set to an appropriate size in consideration of a threshold voltage compensation performance and the like.

The example shown in FIGS. 1 and 3 divides the display panel 10 into the plurality of display blocks BLK1 to BLKj including the plurality of pixel lines L#1 to L#n, respectively (S1). While the example sequentially compensates the threshold voltage and the electron mobility of the driving transistor in a unit of display block, the example simultaneously compensates the threshold voltage of the driving transistor with respect to all of the pixel lines L#1 to L#n belonging to the same display block (S2). The example sequentially compensates the electron mobility of the driving transistor in a unit of pixel line in the same display block (S3). The example implements grayscale by applying and emitting a driving current determined by the gate-source voltage of the driving transistor set at the time of compensation to the organic light emitting diode of each sub-pixel SP (S4).

The electrical characteristics deviation of the driving transistor is compensated by the method of FIG. 3. However, a method of driving in which a compensation operation is performed without overlapping between neighboring display blocks will be described as follows.

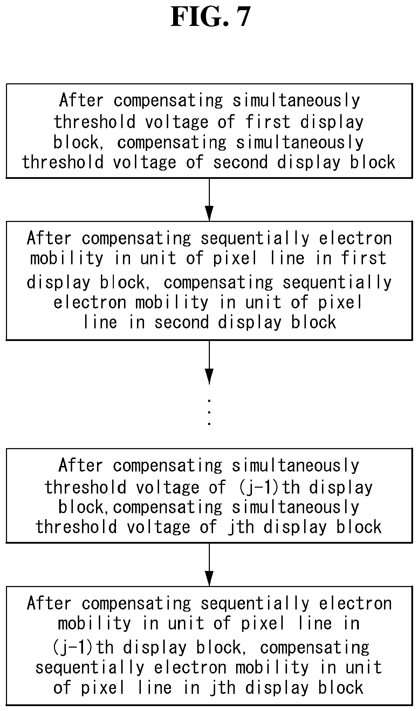

**FIGS. 4 to** 6 are diagrams illustrating a method of driving in which a non-overlapping compensating operation is performed between neighboring display blocks while compensating an electric characteristic deviation of a driving transistor by a method of FIG. 3. **FIG. 7** is a diagram illustrating a method of driving in which an overlapping compensating operation is performed between neighboring display blocks while compensating an electric characteristic deviation of a driving transistor by a method of FIG. 3.

As shown in FIGS. 4 to 6, a display blocks BLK1 to BLKj can perform a non-overlapping compensation operation with each other. The non-overlapping compensation operation will be described as follows.

First, a threshold voltage of a driving transistor is simultaneously compensated for pixel lines L#1 to L#n of a first display block BLK1. This process may be defined as a compensation period (1st Block Vth Comp) of the first display block BLK1. Thereafter, an electron mobility of the driving transistor is sequentially compensated in a unit of pixel line in the first display block BLK1.

Next, a threshold voltage of a driving transistor is simultaneously compensated for pixel lines L#1 to L#n of a second display block BLK2. This process may be defined as a compensation period (2nd Block Vth Comp) of the second display block BLK2. Thereafter, an electron mobility of the driving transistor is sequentially compensated in a unit of pixel line in the second display block BLK2.

The example compensates the threshold voltage and the electron mobility of the driving transistor from the first display block BLK1 to the jth display block BLKj in this manner. On the other hand, the compensation period of each display block is determined as described above, but an emission period in which the display blocks BLK1 to BLKj of a display panel 10 emit light is sequentially performed for each scan line.

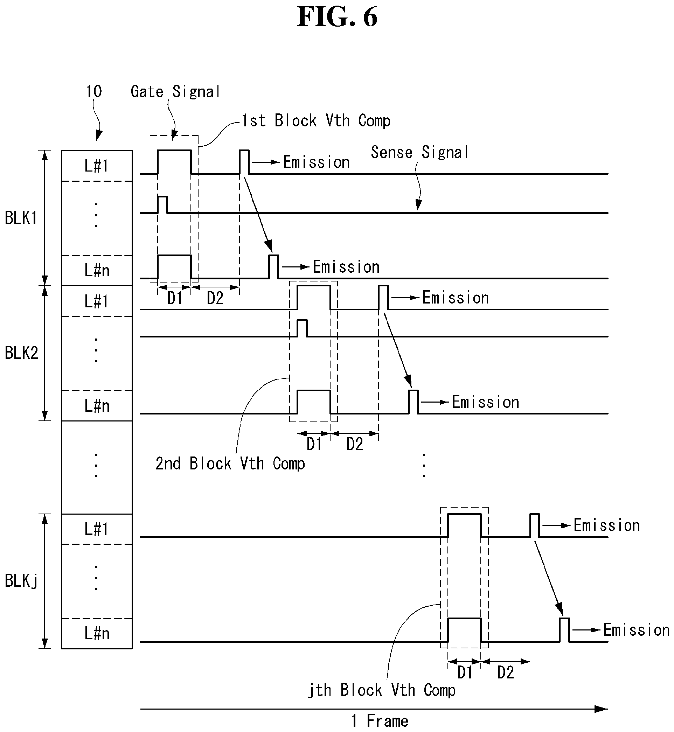

In each display block in FIG. 6, a period during which the threshold voltage of the driving transistor is simultaneously compensated is denoted by "D1", and a period until a data voltage is written after the threshold voltage compensation is denoted by "D2". The electron mobility compensation of the driving transistors is performed simultaneously with the writing of the data voltage.

Among signals applied to the display panel, "Gate Signal" (logic high) is a gate potential control scan signal used to control a gate potential of the driving transistor, and "Sense Signal" (logic high) is a source potential control scan signal used to control a source potential of the driving transistor.

On the other hand, as shown in FIG. 7, a method of driving in which an overlapping compensation operation is performed between neighboring display blocks may be selected as a method of compensating the electrical characteristic deviation of the driving transistor by the method of FIG. 3. The overlapping compensation operation will be described as follows.

First, after the threshold voltage of the driving transistor is simultaneously compensated for the pixel lines L#1 to L#n of the first display block BLK1, the threshold voltage of the driving transistor is simultaneously compensated for the pixel lines L#1 to L#n of the second display block BLK2.

Next, after the electron mobility of the driving transistor is sequentially compensated in a unit of pixel line in the first display block BLK1 in which the threshold voltage of the driving transistor is simultaneously compensated, the electron mobility of the driving transistor is sequentially compensated in a unit of pixel line in the second display block BLK2 in which the threshold voltage of the driving transistor is simultaneously compensated. The example compensates the threshold voltage and the electron mobility of the driving transistor from the first display block BLK1 to the jth display block BLKj in this manner.

As described above, configuration of a sub-pixel circuit must be supported in order to compensate the driving transistor in a unit of display block. Hereinafter, a configuration of the sub-pixel circuit and a method of driving the same will be described but not limited thereto.

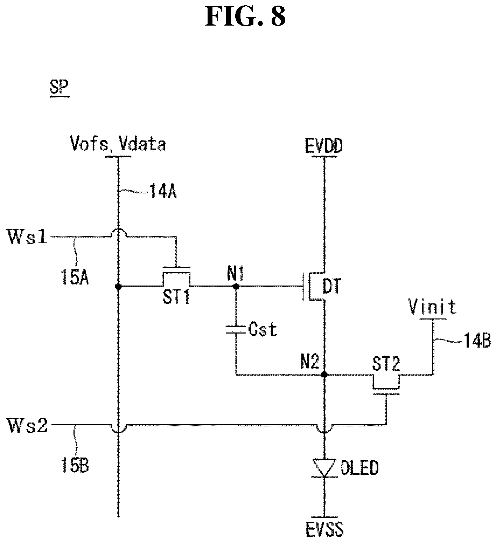

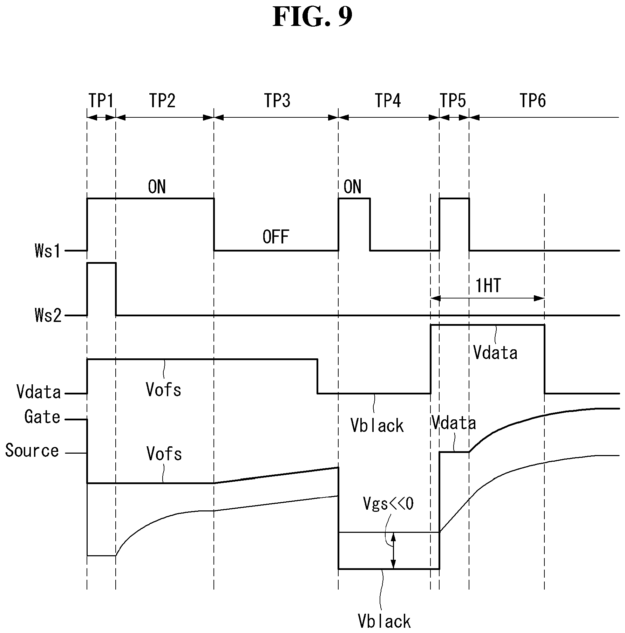

**FIG. 8** is a circuit configuration diagram of a sub-pixel according to a comparative example. **FIG. 9** is a diagram illustrating driving waveforms of a sub-pixel shown in FIG. 8.

As shown in FIG. 8, a sub-pixel SP may include an organic light emitting diode OLED, a driving transistor DT, a storage capacitor Cst, a first switching transistor ST1, and a second switching transistor ST2. A semiconductor layer of the transistors constituting the sub-pixel SP may include amorphous silicon, polysilicon or an oxide.

The driving transistor DT, the first switching transistor ST1, and the second switching transistor ST2 may be of N type, but are not limited thereto. The N-type transistors are turned on in response to a scan signal of logic high and turned off in response to a scan signal of logic low.

The organic light emitting diode OLED emits light in response to a driving current generated from the driving transistor DT. The organic light emitting diode OLED includes an anode electrode connected to a source node N2, a cathode electrode connected to a low potential driving voltage terminal EVSS, and an organic compound layer disposed between the anode electrode and the cathode electrode.

The driving transistor DT controls the driving current flowing in the organic light emitting diode OLED depending on a gate-source voltage Vgs. The driving transistor DT includes a gate electrode connected to a gate node N1, a drain electrode connected to a high potential driving voltage terminal EVDD, and a source electrode connected to the source node N2.

The storage capacitor Cst stores a data voltage and provides the stored data voltage to the gate electrode of the driving transistor DT. One end of the storage capacitor Cst is connected to the gate node N1 and other end is connected to the source node N2.

The first switching transistor ST1 is switched depending on a gate potential control scan signal (first A scan signal) to control a gate potential (gate node N1 potential) of the driving transistor DT. The first switching transistor ST1 includes a gate electrode connected to a first A scan line 15A, a drain electrode connected to a data line 14A, and a source electrode connected to the gate node N1.

The second switching transistor ST2 is switched depending on a source potential control scan signal (first B scan signal) to control a source potential (source node N2 potential) of the driving transistor DT. The second switching transistor ST2 includes a gate electrode connected to a first B scan line 15B, a drain electrode connected to the source node N2, and a source electrode connected to a reference line 14B. The reference line 14B is used to transmit an initialization voltage, a reference voltage, or the like, or to sense the source node N2. The reference line 14B may be connected to the data driver 12 or may be connected to a separate reference output circuit (not shown).

As shown in FIGS. 8 and 9, the sub-pixel SP operates in an order of an initialization period TP1, a first threshold voltage compensation period TP2, a second threshold voltage compensation period TP3, a black data voltage writing period TP4, a data voltage writing and an electron mobility compensation period TP5, and a light emission period TP6.

The initialization period TP1 is a period for applying the initialization voltage Vinit to the source node N2. The first switching transistor ST1 is turned on in response to the gate potential control scan signal Ws1. The second switching transistor ST2 is turned on in response to the source potential control scan signal Ws2. During this period, an offset voltage Vofs is supplied to the data line and the initialization voltage Vinit is supplied to the reference line. Thus, the offset voltage Vofs is applied to the gate node N1, and the initialization voltage Vinit is applied to the source node N2. As a result, the driving transistor DT is turned on since the gate-source voltage becomes higher than a threshold voltage.

The first threshold voltage compensation period TP2 is a period for compensating the threshold voltage of the driving transistor DT. The first switching transistor ST1 is maintained in a turned-on state in response to the gate potential control scan signal Ws1. The second switching transistor ST2 is turned off in response to the source potential control scan signal Ws2. During this period, the offset voltage Vofs is supplied to the data line. Thus, the gate potential Gate of the driving transistor DT is maintained at the offset voltage Vofs. As a result, the source potential of the driving transistor DT gradually rises from the initialization voltage to the threshold voltage by the current Ids flowing between the drain and the source of the driving transistor DT. The compensated threshold voltage of the driving transistor DT during this period is stored in the storage capacitor Cst.

The second threshold voltage compensation period TP3 is a period during which the transistors ST1 and ST2 are electrically floated so that the threshold voltage of the driving transistor DT is stored with sufficient time in the storage capacitor Cst. The first switching transistor ST1 and the second switching transistor ST2 are turned off in response to the gate potential control scan signal Ws1 and the source potential control scan signal Ws2. In addition, the transistors ST1, ST2, and DT of all the pixel lines belonging to the same display block are electrically turned off during the second threshold voltage compensation period TP3.

The black data voltage writing period TP4 is a period for writing a black data voltage Vblack through the data line. The first switching transistor ST1 is turned on in response to the gate potential control scan signal Ws1. The second switching transistor ST2 is maintained in a turned-off state in response to the source potential control scan signal Ws2. During this period, the data line is supplied with the black data voltage Vblack. As a result, a problem that the gate-source voltage of the driving transistor DT set through the threshold voltage compensation varies for each sub-pixel is minimized.

On the other hand, when the black data voltage Vblack is applied, the gate-source voltage Vgs of the driving transistor DT becomes much lower than the threshold voltage (Vth, for example, "0V") of the driving transistor DT. Therefore, a leakage current generated from the driving transistor DT is cut off.

The data voltage writing and the electron mobility compensation period TP5 is a period for writing the data voltage and compensating the electron mobility. The first switching transistor ST1 is turned on in response to the gate potential control scan signal Ws1. The second switching transistor ST2 is maintained in a turned-off state in response to the source potential control scan signal Ws2. During this period, a data voltage Vdata is supplied to the data line. Thus, the data voltage Vdata is applied to the gate node N1 of the driving transistor DT, and the gate potential Gate of the driving transistor DT rises from a level of the black data voltage Vblack to a level of the data voltage Vdata. Then, the source potential (Source) also rises in accordance with the electron mobility characteristic of the driving transistor DT. The storage capacitor Cst stores a voltage (Vdata+Vth-ΔVµ) obtained by subtracting a voltage variation (ΔVµ) in accordance with the electron mobility characteristic from a sum of the data voltage (Vdata) and the threshold voltage (Vth). As a result, the electron mobility of the driving transistor DT is compensated.

The light emission period TP6 is a period for applying the driving current to the organic light emitting diode OLED to emit light. The first switching transistor ST1 and the second switching transistor ST2 are turned off in response to the gate potential control scan signal Ws1 and the source potential control scan signal Ws2. The driving transistor DT is turned on by the voltage level (Vdata+Vth-ΔVµ) stored in the storage capacitor Cst, and supplies the organic light emitting diode OLED with a driving current in which the threshold voltage Vth and the electron mobility are compensated. As a result, the organic light emitting diode OLED emits light based on the driving current whose electric characteristics are compensated.

On the other hand, during the second threshold voltage compensation period TP3 (floating period) included in the driving period for each display block for internal compensation, a leakage current may be caused by a capacitor (OLED cap) component existing in the organic light emitting diode (OLED). However, the embodiment described below can prevent the leakage current problem caused by the capacitor (OLED cap) component existing in the organic light emitting diode (OLED).

### Embodiment

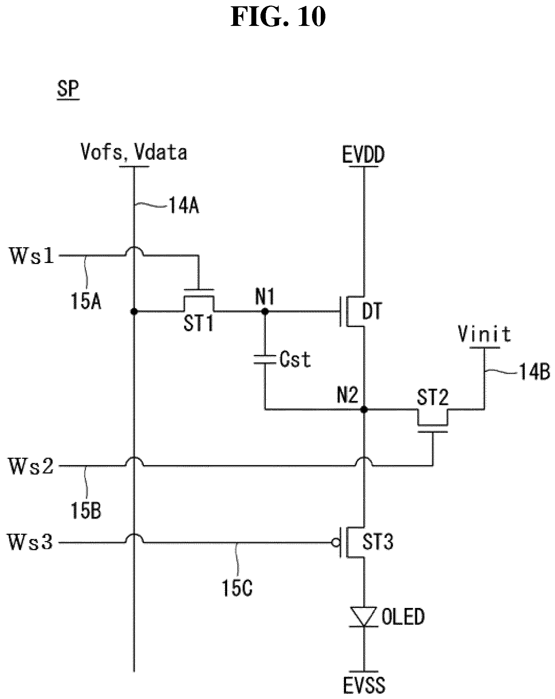

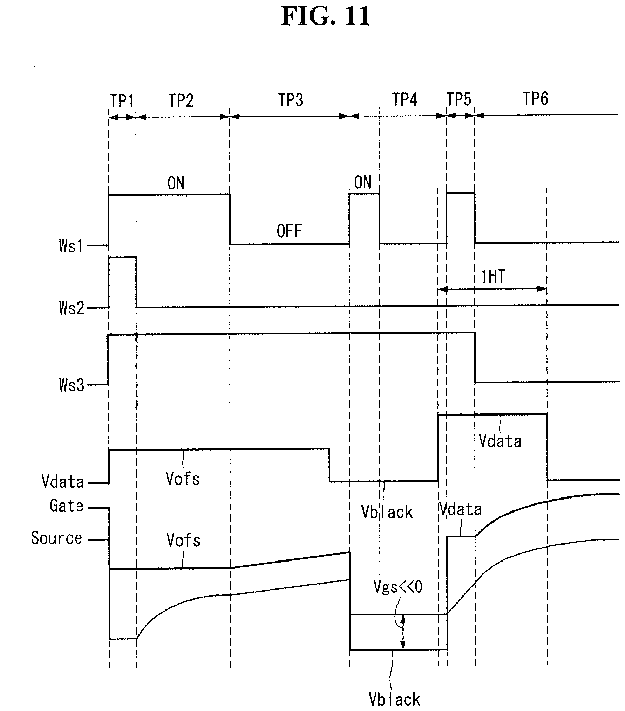

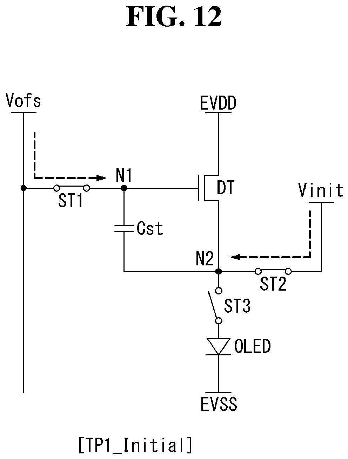

**FIG. 10** is a circuit configuration diagram of a sub-pixel according to an embodiment of the present disclosure. **FIG. 11** is a diagram illustrating driving waveforms of a sub-pixel shown in FIG. 10. **FIGS. 12 to** 17 are diagrams illustrating operation states by period of a sub-pixel according to Figures 10 and 11.

As shown in FIG. 10, a sub-pixel SP may include an organic light emitting diode OLED, a driving transistor DT, a storage capacitor Cst, a first switching transistor ST1, a second switching transistor ST2, and a third switching transistor ST3. A semiconductor layer of the transistors constituting the sub-pixel SP may include amorphous silicon, polysilicon or an oxide.

The driving transistor DT, the first switching transistor ST1 and the second switching transistor ST2 may be of N type, and the third switching transistor ST3 may be of P type, but not limited thereto. The N-type transistors are turned on in response to a scan signal of logic high and turned off in response to a scan signal of logic low. On the contrary, the P -type transistors are turned off in response to the scan signal of logic high and turned on in response to the scan signal of logic low.

The organic light emitting diode OLED emits light in response to a driving current generated from the driving transistor DT. The organic light emitting diode OLED includes an anode electrode connected to a source node N2, a cathode electrode connected to a low potential driving voltage terminal EVSS, and an organic compound layer disposed between the anode electrode and the cathode electrode.

The driving transistor DT controls the driving current flowing in the organic light emitting diode OLED depending on a gate-source voltage Vgs. The driving transistor DT includes a gate electrode connected to a gate node N1, a drain electrode connected to a high potential driving voltage terminal EVDD, and a source electrode connected to the source node N2.

The storage capacitor Cst stores a data voltage and provides the stored data voltage to the gate electrode of the driving transistor DT. One end of the storage capacitor Cst is connected to the gate node N1 and the other end is connected to the source node N2.

The first switching transistor ST1 is switched depending on a gate potential control scan signal (first A scan signal Ws1) to control a gate potential (gate node N1 potential) of the driving transistor DT. The first switching transistor ST1 includes a gate electrode connected to a first A scan line 15A, a drain electrode connected to a data line 14A, and a source electrode connected to the gate node N1.

The second switching transistor ST2 is switched depending on a source potential control scan signal (first B scan signal Ws2) to control a source potential (source node N2 potential) of the drive transistor DT. The second switching transistor ST2 includes a gate electrode connected to a first B scan line 15B, a drain electrode connected to the source node N2, and a source electrode connected to a reference line 14B. The reference line 14B is used to transmit a reference voltage Vref or the like or to sense the source node N2. The reference line 14B may be connected to the data driver 12 or may be connected to a separate reference output circuit (not shown).

The third switching transistor ST3 is switched depending on a leakage preventing scan signal (first C scan signal Ws3) to electrically float the source node N2 of the driving transistor DT and the anode electrode of the organic light emitting diode OLED. The third switching transistor ST3 includes a gate electrode connected to a first C scan line 15C, a drain electrode connected to the source node N2 of the driving transistor DT, and a source electrode connected to the anode electrode of the organic light emitting diode OLED.

As shown in FIGS. 10 to 17, the sub-pixel SP operates in an order of an initialization period TP1, a first threshold voltage compensation period TP2, a second threshold voltage compensation period TP3, a black data voltage writing period TP4, a data voltage writing and an electron mobility compensation period TP5, and a light emission period TP6.

As shown in FIGS. 11 and 12, the initialization period TP1 is a period for applying the initialization voltage Vinit to the source node N2. The first switching transistor ST1 is turned on in response to the gate potential control scan signal Ws1. The second switching transistor ST2 is turned on in response to the source potential control scan signal Ws2. The third switching transistor ST3 is turned off in response to the leakage preventing scan signal Ws3. During this period, an offset voltage Vofs is supplied to the data line 14A and the initialization voltage Vinit is supplied to the reference line 14B. Thus, the offset voltage Vofs is applied to the gate node N1, and the initialization voltage Vinit is applied to the source node N2. As a result, the driving transistor DT is turned on since the gate-source voltage becomes higher than a threshold voltage.

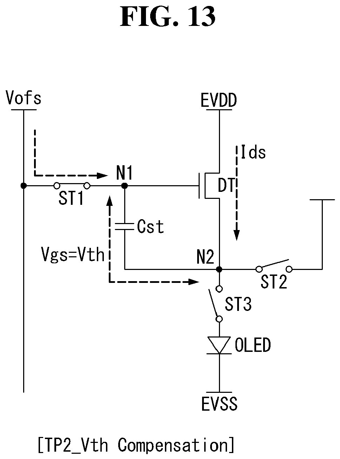

As shown in FIGS. 11 and 13, the first threshold voltage compensation period TP2 is a period for compensating the threshold voltage of the driving transistor DT. The first switching transistor ST1 is maintained in a turned-on state in response to the gate potential control scan signal Ws1. The second switching transistor ST2 is turned off in response to the source potential control scan signal Ws2. The third switching transistor ST3 is maintained in a turned-off state in response to the leakage preventing scan signal Ws3. During this period, the offset voltage Vofs is supplied to the data line 14A. Thus, the gate potential Gate of the driving transistor DT is maintained at the offset voltage Vofs. As a result, the source potential of the driving transistor DT gradually rises from the initialization voltage to the threshold voltage by the current Ids flowing between the drain and the source of the driving transistor DT. The compensated threshold voltage of the driving transistor DT during this period is stored in the storage capacitor Cst. A leakage current generated from the organic light emitting diode OLED is cut off by the third switching transistor ST3.

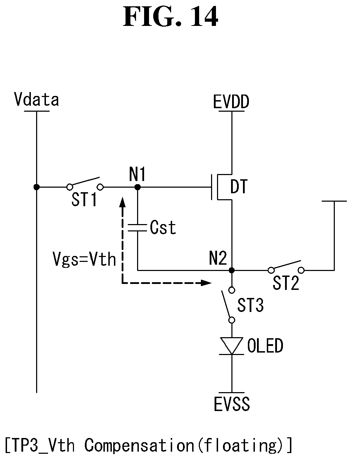

As shown in FIGS. 11 and 14, the second threshold voltage compensation period TP3 is a period during which the transistors ST1 and ST2 are electrically floated so that the threshold voltage of the driving transistor DT is stored with sufficient time in the storage capacitor Cst. The first switching transistor ST1 and the second switching transistor ST2 are turned off in response to the gate potential control scan signal Ws1 and the source potential control scan signal Ws2. The third switching transistor ST3 is maintained in a turned-off state in response to the leakage preventing scan signal Ws3. As a result, the transistors ST1 and ST2 are electrically floated, but the leakage current that may be generated from the organic light emitting diode OLED is cut off by the third switching transistor ST3.

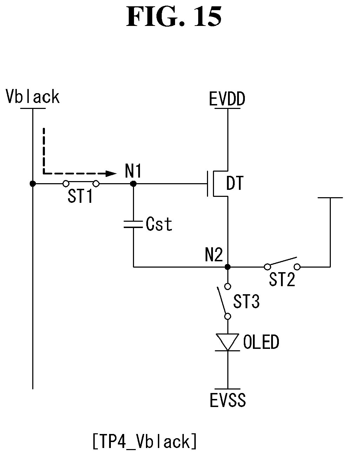

As shown in FIGS. 11 and 15, the black data voltage writing period TP4 is a period for writing a black data voltage Vblack through the data lines. The first switching transistor ST1 is turned on in response to the gate potential control scan signal Ws1. The second switching transistor ST2 is maintained in a turned-off state in response to the source potential control scan signal Ws2. The third switching transistor ST3 is maintained in a turned-off state in response to the leakage preventing scan signal Ws3. During this period, the data line 14A is supplied with the black data voltage Vblack. As a result, a problem that the gate-source voltage of the driving transistor DT set through the threshold voltage compensation varies for each sub-pixel is minimized.

On the other hand, when the black data voltage Vblack is applied, the gate-source voltage Vgs of the driving transistor DT is much lower than the threshold voltage (Vth, for example, "0V") of the driving transistor DT. Therefore, a leakage current generated from the driving transistor DT is cut off. The leakage current generated from the organic light emitting diode OLED is also cut off by the third switching transistor ST3.

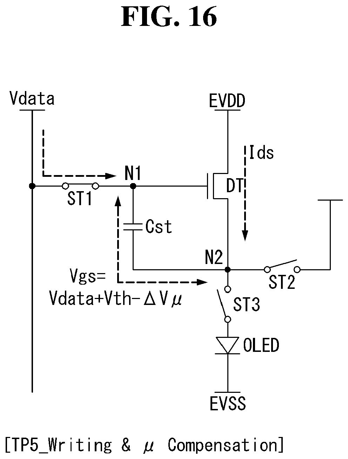

As shown in FIGS. 11 and 16, the data voltage writing and the electron mobility compensation period TP5 is a period for writing the data voltage and compensating for the electron mobility. The first switching transistor ST1 is turned on in response to the gate potential control scan signal Ws1. The second switching transistor ST2 is maintained in a turned-off state in response to the source potential control scan signal Ws2. During this period, a data voltage Vdata is supplied to the data line 14A. The third switching transistor ST3 is maintained in a turned-off state in response to the leakage preventing scan signal Ws3. Thus, the data voltage Vdata is applied to the gate node N1 of the driving transistor DT, and the gate potential Gate of the driving transistor DT rises from a level of the black data voltage Vblack to a level of the data voltage Vdata. Then, the source potential (Source) also rises in accordance with the electron mobility characteristics of the driving transistor DT. As a result, the storage capacitor Cst stores a voltage (Vdata+Vth-ΔVµ) obtained by subtracting a voltage variation (ΔVµ) in accordance with the electron mobility characteristic from a sum of the data voltage (Vdata) and the threshold voltage (Vth). As a result, the electron mobility of the driving transistor DT is compensated. The leakage current generated from the organic light emitting diode OLED is also cut off by the third switching transistor ST3.

As shown in FIGS. 11 and 17, the light emission period TP6 is a period for applying the driving current to the organic light emitting diode OLED to emit light. The first switching transistor ST1 and the second switching transistor ST2 are turned off in response to the gate potential control scan signal Ws1 and the source potential control scan signal Ws2. The third switching transistor ST3 is turned on in response to the leakage preventing scan signal Ws3. The driving transistor DT is turned on by the voltage level (Vdata+Vth-ΔVµ) stored in the storage capacitor Cst, and supplies the organic light emitting diode OLED with a driving current in which the threshold voltage Vth and the electron mobility µ are compensated. As a result, the organic light emitting diode OLED emits light based on the driving current whose electric characteristics are compensated.

On the other hand, in the embodiment according to Figures 10 and 11, the third switching transistor ST3 is turned off for a long time in order to prevent a leakage current problem caused by a capacitor (OLED cap) component existing in the organic light emitting diode (OLED) as an example. This period is a period for preventing current leakage of the organic light emitting diode. However, this is only an example, and the turn-off state of the third switching transistor ST3 may be changed as follows.

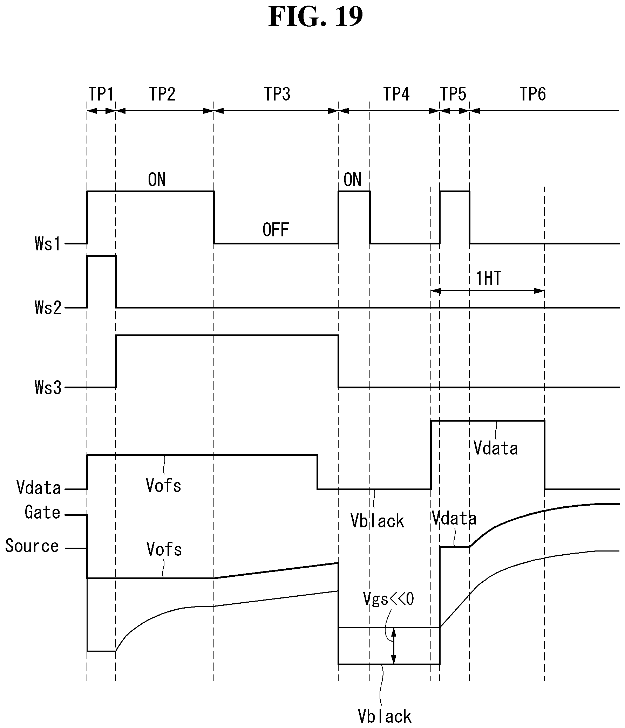

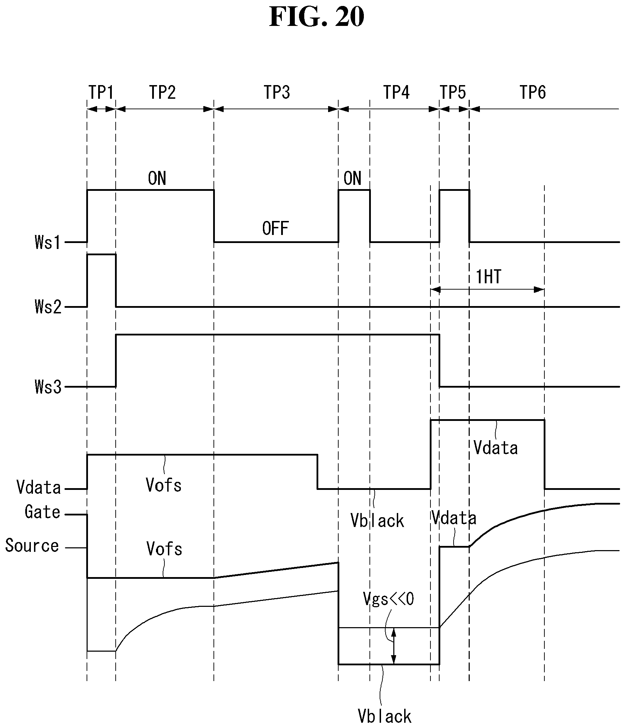

**FIG. 18** is a first modification illustrating driving waveforms of a sub-pixel shown in FIG. 10. **FIG. 19** is a second modification illustrating driving waveforms of a sub-pixel shown in FIG. 10. **FIG. 20** is a third modification illustrating driving waveforms of a sub-pixel shown in FIG. 10.

As shown in FIG. 18, the third switching transistor ST3 may be turned off only in the second threshold voltage compensation period TP3. As shown in FIG. 19, the third switching transistor ST3 may be turned off only in the first threshold voltage compensation period TP2 and the second threshold voltage compensation period TP3. As shown in FIG. 20, the third switching transistor ST3 may be turned off only in the first threshold voltage compensation period TP2, the second threshold voltage compensation period TP3, and the black data voltage writing period TP4.

The third switching transistor ST3 is turned off for a predetermined period to prevent a leakage current problem caused by a capacitor (OLED cap) component existing in the organic light emitting diode (OLED). Therefore, the turn-off period of the third switching transistor ST3 can be optimized in consideration of a capacitor (OLED cap) component present in the organic light emitting diode OLED and a driving method thereof, and thus is not limited to the above description.

As described above, the present disclosure sequentially compensates the threshold voltage and the electron mobility of the driving transistor in a unit of the display block, and compensates for the problem of varying electrical characteristics of the driving transistor. Thus, the present disclosure has an effect of improving lifetime and reliability of the device. In addition, the present disclosure provides a source-follower type internal compensation, and prevents the leakage current caused by the capacitor component existing in the organic light emitting diode during the driving period of each display block performed in the compensation. Thus, the present disclosure has an effect of preventing the problem of block dim on the display panel.

Although a number of illustrative embodiments have been described, it should be understood that numerous other modifications and embodiments can be devised by those skilled in the art that will fall within the scope of the appended claims. In addition, alternative uses will also be apparent to those skilled in the art.

## Claims

1. An electroluminescent display comprising:
a driving transistor (DT) configured to generate a driving current depending on a gate-source voltage (Vgs);
a storage capacitor (Cst) configured to store a data voltage (Vdata) and provide the stored data voltage (Vdata) to a gate electrode (N1) of the driving transistor (DT);
a first switching transistor (ST1) configured to control a gate potential of the driving transistor (DT);
a second switching transistor (ST2) configured to control a source potential of the driving transistor (DT);
a light emitting diode (OLED) configured to emit light in response to the driving current generated from the driving transistor (DT); and
a third switching transistor (ST3) configured to electrically float a source electrode (N2) of the driving transistor (DT) and an anode electrode of the light emitting diode (OLED);
**characterised in that**: the electroluminescent display configured to perform the following steps:
an initialization step during a first time period (TP1) in which the first switching transistor (ST1) is turned on to supply an offset voltage (Vofs) from a data line (14A) to the gate electrode (N1) of the driving transistor (DT), and the second switching transistor (ST2) is turned on to apply an initialization voltage (Vinit) to the source electrode (N2) of the driving transistor (DT);
a first threshold voltage compensation step of compensating a threshold voltage (Vth) of the driving transistor (DT) during a second time period (TP2) in which the first switching transistor (ST1) is turned on to supply an offset voltage (Vofs) from the data line (14A) to the gate electrode (N1) of the driving transistor (DT) and the second switching transistor (ST2) is turned off;
a second threshold voltage compensation step during a third time period (TP3) in which the first switching transistor (ST1) and the second switching transistor (ST2) are turned off so that the threshold voltage (Vth) of the driving transistor (DT) is stored in the storage capacitor (Cst);
a black data voltage writing step during a fourth time period (TP4) in which the first switching transistor (ST1) is turned on to write a black data voltage (Vblack) from the data line (14A) to the gate electrode (N1) of the driving transistor (DT), and the second switching transistor (ST2) is turned off;
a data voltage writing and electron mobility compensation step during a fifth time period (TP5) in which the first switching transistor (ST1) is turned on to write a data voltage (Vdata) from the data line (14A) to the gate electrode (N1) of the driving transistor (DT), and the second switching transistor (ST2) is turned off, the data voltage (Vdata) compensating an electron mobility of the driving transistor (DT); and
a light emission step during a sixth time period (TP6) in which the first and second switching transistors (ST1, ST2) are turned off and the third switching transistor (ST3) is turned on to cause the light emitting diode (OLED) to emit light based on the driving current generated from the driving transistor (DT),
wherein the first through sixth time periods (TP1 - TP6) succeed each other **in that** exact order, and the third switching transistor (ST3) is turned off during at least the third time period (TP3) of
the first to fifth time periods (TP1...TP5) to prevent current leakage of the light emitting diode (OLED).

2. The electroluminescent display of claim 1,
wherein the anode electrode of the light emitting diode (OLED) is connected to the source electrode of the driving transistor (DT), and a cathode electrode of the light emitting diode (OLED) is connected to a low potential driving voltage terminal (EVSS),
one end of the storage capacitor (Cst) is connected to the gate electrode (N1) of the driving transistor (DT), and the other end of the storage capacitor (Cst) is connected to the source electrode (N2) of the driving transistor (DT),
a drain electrode of the driving transistor (DT) is connected to a high potential driving voltage terminal (EVDD),
a gate electrode of the first switching transistor (ST1) is connected to a first scan line (15A), a drain electrode of the first switching transistor (ST1) is connected to the data line (14A), a source electrode of the first switching transistor (ST1) is connected to the gate electrode (N1) of the driving transistor (DT),
a gate electrode of the second switching transistor (ST2) is connected to a second scan line (15B), a drain electrode of the second switching transistor (ST2) is connected to the source electrode (N2) of the driving transistor (DT), a source electrode of the second switching transistor (ST2) is connected to a reference line (14B),
a gate electrode of the third switching transistor (ST3) is connected to a third scan line (15B), a drain electrode of the third switching transistor (ST3) is connected to the source electrode (N2) of the driving transistor (DT), and a source electrode of the third switching transistor (ST3) is connected to the anode electrode of the light emitting diode (OLED).

3. A method of driving an electroluminescent display, comprising:
an initialization step during a first time period (TP1) in which a first switching transistor (ST1) is turned on to supply an offset voltage (Vofs) from a data line (14A) to a gate electrode (N1) of a driving transistor (DT), and a second switching transistor (ST2) is turned on to apply an initialization voltage (Vinit) to a source electrode (N2) of the driving transistor (DT);
a first threshold voltage compensation step of compensating a threshold voltage (Vth) of the driving transistor (DT) during a second time period (TP2) in which the first switching transistor (ST1) is turned on to supply an offset voltage (Vofs) from the data line (14A) to the gate electrode (N1) of the driving transistor (DT) and the second switching transistor (ST2) is turned off;
a second threshold voltage compensation step during a third time period (TP3) in which the first switching transistor (ST1) and the second switching transistor (ST2) are turned off so that the threshold voltage (Vth) of the driving transistor (DT) is stored in a storage capacitor (Cst);
a black data voltage writing step during a fourth time period (TP4) in which the first switching transistor (ST1) is turned on to write a black data voltage (Vblack) from the data line (14A) to the gate electrode (N1) of the driving transistor (DT), and the second switching transistor (ST2) is turned off;
a data voltage writing and electron mobility compensation step during a fifth time period (TP5) in which the first switching transistor (ST1) is turned on to write a data voltage (Vdata) from the data line (14A) to the gate electrode (N1) of the driving transistor (DT), and the second switching transistor (ST2) is turned off, the data voltage (Vdata) compensating an electron mobility of the driving transistor (DT); and
a light emission step during a sixth time period (TP6) in which the first and second switching transistors (ST1, ST2) are turned off and a third switching transistor (ST3) is turned on to cause the light emitting diode (OLED) to emit light based on driving current generated from the driving transistor (DT),
wherein the first through sixth time periods (TP1 - TP6) succeed each other in that exact order, and wherein
the third switching transistor (ST3) is turned off as a current leakage prevention step during at least the third time period (TP3) of the first to fifth time periods (TP1...TP5) to prevent current leakage of the light emitting diode (OLED), and wherein the electroluminescent display is the electroluminescent display of either of claims 1 or 2.

4. The method of claim 3, wherein transistors of sub-pixels (SP) belonging to at least one pixel line (L#1, ..., L#n) are all turned off during the current leakage prevention step of the light emitting diode (OLED).

5. The method of claim 3 or 4, wherein the current leakage prevention step of the light emitting diode (OLED) is performed from the first threshold voltage compensation step (TP2) to the data voltage writing and the electron mobility compensation step (TP5)

## Patentansprüche

1. Elektrolumineszenzanzeige, aufweisend:
einen Treibertransistor (DT), der konfiguriert ist, um einen Treiberstrom in Abhängigkeit von einer Gate-Source-Spannung (Vgs) zu erzeugen,
einen Speicherkondensator (Cst), der konfiguriert ist, um eine Datenspannung (Vdata) zu speichern und die gespeicherte Datenspannung (Vdata) an eine Gate-Elektrode (N1) des Treibertransistors (DT) bereitzustellen,
einen ersten Schalttransistor (ST1), der konfiguriert ist, um ein Gate-Potential des Treibertransistors (DT) zu steuern,
einen zweiten Schalttransistor (ST2), der konfiguriert ist, um ein Source-Potential des Treibertransistors (DT) zu steuern,
eine lichtemittierende Diode (OLED), die konfiguriert ist, um als Reaktion auf den vom Treibertransistor (DT) erzeugten Treiberstrom Licht zu emittieren, und
einen dritten Schalttransistor (ST3), der konfiguriert ist, um eine Source-Elektrode (N2) des Treibertransistors (DT) und eine Anodenelektrode der lichtemittierenden Diode (OLED) elektrisch schweben zu lassen,
**dadurch gekennzeichnet, dass**:
die Elektrolumineszenzanzeige konfiguriert ist, um die folgenden Schritte durchzuführen:
einen Initialisierungsschritt während einer ersten Zeitperiode (TP1), bei dem der erste Schalttransistor (ST1) eingeschaltet wird, um eine Offsetspannung (Vofs) von einer Datenleitung (14A) an die Gate-Elektrode (N1) des Treibertransistors (DT) zuzuführen, und der zweite Schalttransistor (ST2) eingeschaltet wird, um eine Initialisierungsspannung (Vinit) an die Source-Elektrode (N2) des Treibertransistors (DT) anzulegen,
einen ersten Schwellenspannungskompensationsschritt zum Kompensieren einer Schwellenspannung (Vth) des Treibertransistors (DT) während einer zweiten Zeitperiode (TP2), bei dem der erste Schalttransistor (ST1) eingeschaltet wird, um eine Offsetspannung (Vofs) von der Datenleitung (14A) an die Gate-Elektrode (N1) des Treibertransistors (DT) zuzuführen, und der zweite Schalttransistor (ST2) ausgeschaltet wird,
einen zweiten Schwellenspannungskompensationsschritt während einer dritten Zeitperiode (TP3), bei dem der erste Schalttransistor (ST1) und der zweite Schalttransistor (ST2) ausgeschaltet werden, so dass die Schwellenspannung (Vth) des Treibertransistors (DT) in dem Speicherkondensator (Cst) gespeichert wird,
einen Schwarzdatenspannungsschreibschritt während einer vierten Zeitperiode (TP4), bei dem der erste Schalttransistor (ST1) eingeschaltet wird, um eine Schwarzdatenspannung (Vblack) von der Datenleitung (14A) auf die Gate-Elektrode (N1) des Treibertransistors (DT) zu schreiben, und der zweite Schalttransistor (ST2) ausgeschaltet wird,
einen Datenspannungsschreib- und Elektronenmobilitätskompensationsschritt während einer fünften Zeitperiode (TP5), bei dem der erste Schalttransistor (ST1) eingeschaltet wird, um eine Datenspannung (Vdata) von der Datenleitung (14A) auf die Gate-Elektrode (N1) des Treibertransistors (DT) zu schreiben, und der zweite Schalttransistor (ST2) ausgeschaltet wird, wobei die Datenspannung (Vdata) eine Elektronenmobilität des Treibertransistors (DT) kompensiert, und
einen Lichtemissionsschritt während einer sechsten Zeitperiode (TP6), bei dem der erste und der zweite Schalttransistor (ST1, ST2) ausgeschaltet werden und der dritte Schalttransistor (ST3) eingeschaltet wird, um zu bewirken, dass die lichtemittierende Diode (OLED) Licht auf der Grundlage des von dem Treibertransistor (DT) erzeugten Treiberstroms emittiert,
wobei die erste bis sechste Zeitperiode (TP1 - TP6) in dieser exakten Reihenfolge aufeinander folgen und der dritte Schalttransistor (ST3) während zumindest der dritten Zeitperiode (TP3) der ersten bis fünften Zeitperiode (TP1...TP5) ausgeschaltet wird, um einen Leckstrom der lichtemittierenden Diode (OLED) zu verhindern.

2. Elektrolumineszenzanzeige gemäß Anspruch 1, wobei die Anodenelektrode der lichtemittierenden Diode (OLED) mit der Source-Elektrode des Treibertransistors (DT) verbunden ist und eine Kathodenelektrode der lichtemittierenden Diode (OLED) mit einem Niederpotential-Treiberspannungsanschluss (EVSS) verbunden ist,
ein Ende des Speicherkondensators (Cst) mit der Gate-Elektrode (N1) des Treibertransistors (DT) verbunden ist, und das andere Ende des Speicherkondensators (Cst) mit der Source-Elektrode (N2) des Treibertransistors (DT) verbunden ist,
eine Drain-Elektrode des Treibertransistors (DT) mit einem Hochpotential-Treiberspannungsanschluss (EVDD) verbunden ist,
eine Gate-Elektrode des ersten Schalttransistors (ST1) mit einer ersten Abtastleitung (15A) verbunden ist, eine Drain-Elektrode des ersten Schalttransistors (ST1) mit der Datenleitung (14A) verbunden ist, eine Source-Elektrode des ersten Schalttransistors (ST1) mit der Gate-Elektrode (N1) des Treibertransistors (DT) verbunden ist,
eine Gate-Elektrode des zweiten Schalttransistors (ST2) mit einer zweiten Abtastleitung (15B) verbunden ist, eine Drain-Elektrode des zweiten Schalttransistors (ST2) mit der Source-Elektrode (N2) des Treibertransistors (DT) verbunden ist, eine Source-Elektrode des zweiten Schalttransistors (ST2) mit einer Referenzleitung (14B) verbunden ist,
eine Gate-Elektrode des dritten Schalttransistors (ST3) mit einer dritten Abtastleitung (15B) verbunden ist, eine Drain-Elektrode des dritten Schalttransistors (ST3) mit der Source-Elektrode (N2) des Treibertransistors (DT) verbunden ist und eine Source-Elektrode des dritten Schalttransistors (ST3) mit der Anodenelektrode der lichtemittierenden Diode (OLED) verbunden ist.

3. Verfahren zum Ansteuern einer Elektrolumineszenzanzeige, aufweisend:
einen Initialisierungsschritt während einer ersten Zeitperiode (TP1), bei dem ein erster Schalttransistor (ST1) eingeschaltet wird, um eine Offsetspannung (Vofs) von einer Datenleitung (14A) an eine Gate-Elektrode (N1) eines Treibertransistors (DT) bereitzustellen, und ein zweiter Schalttransistor (ST2) eingeschaltet wird, um eine Initialisierungsspannung (Vinit) an eine Source-Elektrode (N2) des Treibertransistors (DT) anzulegen,
einen ersten Schwellenspannungskompensationsschritt zum Kompensieren einer Schwellenspannung (Vth) des Treibertransistors (DT) während einer zweiten Zeitperiode (TP2), bei dem der erste Schalttransistor (ST1) eingeschaltet wird, um eine Offsetspannung (Vofs) von der Datenleitung (14A) an die Gate-Elektrode (N1) des Treibertransistors (DT) zuzuführen, und der zweite Schalttransistor (ST2) ausgeschaltet wird,
einen zweiten Schwellenspannungskompensationsschritt während einer dritten Zeitperiode (TP3), bei dem der erste Schalttransistor (ST1) und der zweite Schalttransistor (ST2) ausgeschaltet werden, so dass die Schwellenspannung (Vth) des Treibertransistors (DT) in einem Speicherkondensator (Cst) gespeichert wird,
einen Schwarzdatenspannungsschreibschritt während einer vierten Zeitperiode (TP4), bei dem der erste Schalttransistor (ST1) eingeschaltet wird, um eine Schwarzdatenspannung (Vblack) von der Datenleitung (14A) auf die Gate-Elektrode (N1) des Treibertransistors (DT) zu schreiben, und der zweite Schalttransistor (ST2) ausgeschaltet wird,
einen Datenspannungsschreib- und Elektronenmobilitätskompensationsschritt während einer fünften Zeitperiode (TP5), bei dem der erste Schalttransistor (ST1) eingeschaltet wird, um eine Datenspannung (Vdata) von der Datenleitung (14A) auf die Gate-Elektrode (N1) des Treibertransistors (DT) zu schreiben, und der zweite Schalttransistor (ST2) ausgeschaltet wird, wobei die Datenspannung (Vdata) eine Elektronenmobilität des Treibertransistors (DT) kompensiert, und
einen Lichtemissionsschritt während einer sechsten Zeitperiode (TP6), bei dem der erste und der zweite Schalttransistor (ST1, ST2) ausgeschaltet werden und ein dritter Schalttransistor (ST3) eingeschaltet wird, um zu bewirken, dass die lichtemittierende Diode (OLED) Licht auf der Grundlage von von dem Treibertransistor (DT) erzeugtem Treiberstrom emittiert,
wobei die erste bis sechste Zeitperiode (TP1 - TP6) in dieser exakten Reihenfolge aufeinander folgen, und wobei
der dritte Schalttransistor (ST3) als ein Leckstromverhinderungsschritt während mindestens der dritten Zeitperiode (TP3) der ersten bis fünften Zeitperiode (TP1...TP5) ausgeschaltet wird, um einen Leckstrom der lichtemittierenden Diode (OLED) zu verhindern,
und wobei die Elektrolumineszenzanzeige die Elektrolumineszenzanzeige gemäß einem der Ansprüche 1 oder 2 ist.

4. Verfahren gemäß Anspruch 3, wobei Transistoren von Subpixeln (SP), die zu mindestens einer Pixelleitung (L#1, ..., L#n) gehören, während des Leckstromverhinderungsschrittes der lichtemittierenden Diode (OLED) alle ausgeschaltet werden.

5. Verfahren gemäß Anspruch 3 oder 4, wobei der Leckstromverhinderungsschritt der lichtemittierenden Diode (OLED) von dem ersten Schwellenspannungskompensationsschritt (TP2) bis zum Datenspannungsschreib- und Elektronenmobilitätskompensationsschritt (TP5) durchgeführt wird.

## Revendications

1. Affichage électroluminescent comprenant :
un transistor de commande (DT) configuré pour générer un courant de commande selon une tension grille - source (Vgs) ;
un condensateur de stockage (Cst) configuré pour stocker une tension de données (Vdata), et pour fournir la tension de données stockée (Vdata) à l'électrode de grille (N1) du transistor de commande (DT) ;
un premier transistor de commutation (ST1) configuré pour commander le potentiel de grille du transistor de commande (DT) ;
un deuxième transistor de commutation (ST2) configuré pour commander le potentiel de source du transistor de commande (DT) ;
une diode électroluminescente (OLED) configurée pour émettre une lumière en réponse au courant de commande généré par le transistor de commande (DT) ; et
un troisième transistor de commutation (ST3) configuré pour faire flotter électriquement l'électrode de source (N2) du transistor de commande (DT), et l'électrode d'anode de la diode électroluminescente (OLED) ;
**caractérisé en ce que** :
l'affichage électroluminescent est configuré pour exécuter les étapes suivantes :
une étape d'initialisation au cours d'une première période de temps (TP1), dans laquelle le premier transistor de commutation (ST1) est mis en service afin de fournir une tension de décalage (Vofs) à partir d'une ligne de données (14A), à l'électrode de grille (N1) du transistor de commande (DT), et le deuxième transistor de commutation (ST2) est mis en service afin d'appliquer une tension d'initialisation (Vinit) à l'électrode de source (N2) du transistor de commande (DT) ;
une première étape de compensation de tension de seuil, consistant à compenser une tension de seuil (Vth) du transistor de commande (DT) au cours d'une deuxième période de temps (TP2), dans laquelle le premier transistor de commutation (ST1) est mis en service afin de fournir une tension de décalage (Vofs) à partir de la ligne de données (14A), à l'électrode de grille (N1) du transistor de commande (DT), et le deuxième transistor de commutation (ST2) est mis hors service ;
une deuxième étape de compensation de tension de seuil au cours d'une troisième période de temps (TP3), dans laquelle le premier transistor de commutation (ST1) et le deuxième transistor de commutation (ST2) sont mis hors service, de telle sorte que la tension de seuil (Vth) du transistor de commande (DT) soit stockée dans le condensateur de stockage (Cst) ;
une étape d'écriture de tension de données de noir au cours d'une quatrième période de temps (TP4), dans laquelle le premier transistor de commutation (ST1) est mis en service afin d'écrire une tension de données de noir (Vblack) à partir de la ligne de données (14A), vers l'électrode de grille (N1) du transistor de commande (DT), et le deuxième transistor de commutation (ST2) est mis hors service ;
une étape d'écriture de tension de données et de compensation de la mobilité des électrons au cours d'une cinquième période de temps (TP5), dans laquelle le premier transistor de commutation (ST1) est mis en service afin d'écrire une tension de données (Vdata) à partir de la ligne de données (14A), vers l'électrode de grille (N1) du transistor de commande (DT), et le deuxième transistor de commutation (ST2) est mis hors service, la tension de données (Vdata) compensant la mobilité des électrons du transistor de commande (DT) ; et
une étape d'émission de lumière pendant une sixième période de temps (TP6), dans laquelle les premier et deuxième transistors de commutation (ST1, ST2) sont mis hors service, et le troisième transistor de commutation (ST3) est mis en service afin de faire émettre une lumière par la diode électroluminescente (OLED), sur la base du courant de commande généré par le transistor de commande (DT),
dans lequel les six périodes de temps (TP1 - TP6) se succèdent les unes aux autres dans cet ordre précis, et le troisième transistor de commutation (ST3) est mis hors service pendant au moins la troisième période de temps (TP3) des cinq périodes de temps (TP1 TP5) afin d'empêcher une fuite de courant de la diode électroluminescente (OLED).

2. Affichage électroluminescent selon la revendication 1,
dans lequel l'électrode d'anode de la diode électroluminescente (OLED) est connectée à l'électrode de source du transistor de commande (DT), et l'électrode de cathode de la diode électroluminescente (OLED) est connectée à la borne de tension de commande au potentiel bas (EVSS),
une extrémité du condensateur de stockage (Cst) est connectée à l'électrode de grille (N1) du transistor de commande (DT), et l'autre extrémité du condensateur de stockage (Cst) est connectée à l'électrode de source (N2) du transistor de commande (DT),
l'électrode de drain du transistor de commande (DT) est connectée à la borne de tension de commande au potentiel haut (EVDD),
l'électrode de grille du premier transistor de commutation (ST1) est connectée à une première ligne de balayage (15A), l'électrode de drain du premier transistor de commutation (ST1) est connectée à la ligne de données (14A), l'électrode de source du premier transistor de commutation (ST1) est connectée à l'électrode de grille (N1) du transistor de commande (DT),
l'électrode de grille du deuxième transistor de commutation (ST2) est connectée à une deuxième ligne de balayage (15B), l'électrode de drain du deuxième transistor de commutation (ST2) est connectée à l'électrode de source (N2) du transistor de commande (DT), l'électrode de source du deuxième transistor de commutation (ST2) est connectée à une ligne de référence (14B),
l'électrode de grille du troisième transistor de commutation (ST3) est connectée à une troisième ligne de balayage (15B), l'électrode de drain du troisième transistor de commutation (ST3) est connectée à l'électrode de source (N2) du transistor de commande (DT), et l'électrode de source du troisième transistor de commutation (ST3) est connectée à l'électrode d'anode de la diode électroluminescente (OLED),

3. Procédé de commande d'un affichage électroluminescent, comprenant :
une étape d'initialisation au cours d'une première période de temps (TP1), dans laquelle un premier transistor de commutation (ST1) est mis en service afin de fournir une tension de décalage (Vofs) à partir d'une ligne de données (14A), à l'électrode de grille (N1) du transistor de commande (DT), et un deuxième transistor de commutation (ST2) est mis en service afin d'appliquer une tension d'initialisation (Vinit) à l'électrode de source (N2) du transistor de commande (DT) ;
une première étape de compensation de tension de seuil, consistant à compenser une tension de seuil (Vth) du transistor de commande (DT) au cours d'une deuxième période de temps (TP2), dans laquelle le premier transistor de commutation (ST1) est mis en service afin de fournir une tension de décalage (Vofs) à partir de la ligne de données (14A), à l'électrode de grille (N1) du transistor de commande (DT), et le deuxième transistor de commutation (ST2) est mis hors service ;
une deuxième étape de compensation de tension de seuil au cours d'une troisième période de temps (TP3), dans laquelle le premier transistor de commutation (ST1) et le deuxième transistor de commutation (ST2) sont mis hors service, de telle sorte que la tension de seuil (Vth) du transistor de commande (DT) soit stockée dans un condensateur de stockage (Cst) ;
une étape d'écriture de tension de données de noir au cours d'une quatrième période de temps (TP4), dans laquelle le premier transistor de commutation (ST1) est mis en service afin d'écrire une tension de données de noir (Vblack) à partir de la ligne de données (14A), vers l'électrode de grille (N1) du transistor de commande (DT), et le deuxième transistor de commutation (ST2) est mis hors service ;
une étape d'écriture de tension de données et de compensation de la mobilité des électrons au cours d'une cinquième période de temps (TP5), dans laquelle le premier transistor de commutation (ST1) est mis en service afin d'écrire une tension de données (Vdata) à partir de la ligne de données (14A), vers l'électrode de grille (N1) du transistor de commande (DT), et le deuxième transistor de commutation (ST2) est mis hors service, la tension de données (Vdata) compensant la mobilité des électrons du transistor de commande (DT) ; et
une étape d'émission de lumière pendant une sixième période de temps (TP6), dans laquelle les premier et deuxième transistors de commutation (ST1, ST2) sont mis hors service, et un troisième transistor de commutation (ST3) est mis en service afin de faire émettre une lumière par la diode électroluminescente (OLED), sur la base du courant de commande généré par le transistor de commande (DT),
dans lequel les six périodes de temps (TP1 - TP6) se succèdent les unes aux autres dans cet ordre précis, et
dans lequel le troisième transistor de commutation (ST3) est mis hors service en tant qu'étape de prévention d'un courant de fuite au cours d'au moins la troisième période de temps (TP3) des cinq périodes de temps (TP1 ... TP5), afin d'empêcher une fuite de courant de la diode électroluminescente (OLED), et
dans lequel l'affichage électroluminescent est l'affichage électroluminescent selon la revendication 1 ou 2.

4. Procédé selon la revendication 3,
dans lequel les transistors des pixels secondaires (SP) appartenant au moins à une ligne de pixels (L#1 . L#n), sont tous mis hors service pendant l'étape de prévention d'un courant de fuite de la diode électroluminescente (OLED).

5. Procédé selon la revendication 3 ou 4,
dans lequel l'étape de prévention d'un courant de fuite de la diode électroluminescente (OLED), est exécutée à partir la première étape de compensation de tension de seuil (TP2), jusqu'à l'étape d'écriture de tension de données et de compensation de la mobilité des électrons (TP5).
